# EUROPÄISCHE PATENTSCHRIFT

(11) **EP 1 853 101 B1**
(45) Veröffentlichungstag und Bekanntmachung des Hinweises auf die Patenterteilung: **29.10.2008**
(21) Anmeldenummer: 07008287.0
(22) Anmeldetag: 24.04.2007
(51) Int. Cl.: H05K 7/20, H05K 7/14

(54) **Baugruppenträger mit einem Gehäuse zur Aufnahme von Steckbaugruppen**
Components carrier with a casing for plug-in components
Support pour composants doté d'un boîtier destiné à la réception de modules enfichables

(30) Priorität: 06.05.2006 DE 202006007275 U
(43) Veröffentlichungstag der Anmeldung: 07.11.2007
(73) Patentinhaber: Schroff GmbH, 75334 Straubenhardt (DE)
(72) Erfinder: Herrmann, Ralf, 75331 Engelsbrand (DE); Joist, Michael, 76571 Gaggenau (DE); Kempf, Heinz, 75365 Calw (DE); Pawlowski, Adam, 76337 Waldbronn-Reichenbach (DE); Rheinschmitt, Liane, 76275 Ettlingen (DE)
(74) Vertreter: Petirsch, Markus

(56) Entgegenhaltungen:
- EP-A- 0 580 412
- DE-A1- 4 327 444
- DE-U1-4202004 010 20

## Beschreibung

Die vorliegende Erfindung betrifft einen Baugruppenträger zum Einstecken und Herausziehen von elektronischen Steckbaugruppen mit einem Gehäuse, das eine Frontabdeckplatte und eine Kühleinrichtung für Steckbaugruppen hat.

Die Leistungsaufnahme von elektronischen Steckbaugruppen wird heutzutage immer größer. Damit verbunden steigen die Abwärme sowie die Wärmeleistung. Für einige Baugruppen müssen inzwischen besondere Kühleinrichtungen vorgesehen werden, mit der die Steckbaugruppe mittels Flüssigkeitskühlung gekühlt wird.

Aus der DE 102 10 480 A1 ist ein Gehäuse mit elektronischen Baugruppen bekannt, indem jeder Baugruppe eine fest installierte flüssigkeitsdurchströmte Kühlplatte zugeordnet ist. Diese Anordnung weist jedoch einen schwierigen Aufbau des Kühlübergangs auf die steck- und ziehbaren Steckbaugruppen mit ihren zu kontaktierenden elektronischen Bauelementen auf.

Die DE 43 27 444 A1 beschreibt eine Kühleinrichtung für einen Schaltschrank mit elektrischen Geräten, die flüssigkeitsgekühlt sind. Die flüssigkeitsgekühlten Komponenten sind jeweils über die Vorlaufleitung und eine Rücklaufleitung an einen gemeinsamen Verteiler angeschlossen, der vorzugsweise als Block ausgebildet ist. Nachteilig sind ein relativ komplizierter Gesamtaufbau und ebenso ein schwierig zu bewerkstelligender Wärmeübergang.

Die DE 20 2004 010 204 U1 beschreibt einen Baugruppenträger mit einem Gehäuse und mit modularen elektronischen Baugruppen, die einsteckbar und herausziehbar sind. Der Baugruppenträger weist mindestens einen Flüssigkeitsverteiler im Gehäuse auf. Die Flüssigkeitsverteiler sind im Gehäuse oberhalb bzw. unterhalb des Einschubbereichs der Steckbaugruppen angeordnet. Das beschriebene Gehäuse ist auf eine reine Flüssigkeitskühlung ausgelegt. Bei dieser Ausführungsform muss also von vornherein eine Flüssigkeitskühlung im Gehäuse des Baugruppenträgers vorgesehen sein. Eine nachträgliche Montage in einen luftgekühlten Baugruppenträger ist nicht oder nur sehr schwer möglich.

Bei vielen Baugruppenträgern werden jedoch einzelne Steckbaugruppen im nachhinein aufgerüstet bzw. durch aktuellere, leistungsfähigere Steckbaugruppen ersetzt, so dass nachträglich eine Flüssigkeitskühlung für einzelne oder alle Steckbaugruppen vorzusehen ist.

Es ist daher Aufgabe der vorliegenden Erfindung, einen Baugruppenträger mit einem Gehäuse zur Aufnahme von elektronischen Steckbaugruppen zu schaffen, der nachträglich auf einfache Weise mit einer Flüssigkeitskühlung ausgestattet werden kann. Dies soll insbesondere bei Gehäusen mit Baugruppenträgern möglich sein, die in einem Elektronikschrank eingebaut sind.

Die Lösung der vorliegenden Aufgabe erfolgt durch die Merkmale des Anspruchs 1. Die Unteransprüche haben vorteilhafte Weiterbildungen der Erfindung zum Inhalt.

Der erfindungsgemäße Baugruppenträger zum Einstecken und Herausziehen von elektronischen Steckbaugruppen schließt eine Kühleinrichtung für die Steckbaugruppen und ein Gehäuse mit einer Frontabdeckplatte ein, in dem die Steckbaugruppen aufgenommen werden. Die Kühleinrichtung umfasst einen auf der Steckbaugruppe angeordneten Kühlkörper und einen Flüssigkeitsverteiler, der über eine Vorlaufleitung und eine Rücklaufleitung mit dem Kühlkörper in Strömungsverbindung steht. Der Flüssigkeitsverteiler ist außen im Frontbereich des Baugruppenträgers angeordnet, bevorzugt an einer Außenseite des Baugruppenträgers, insbesondere an einer Außenseite der Front.

Erfindungsgemäß wird durch diese Ausgestaltung ein einfaches Nachrüsten eines solchen Verteilers am Baugruppenträger ermöglicht. Wenn einzelne Steckbaugruppen ausgetauscht werden und für diese ausgetauschten Baugruppen der Bedarf einer Flüssigkeitskühlung besteht, kann auf einfache Weise ein Flüssigkeitsverteiler an der Außenseite des Baugruppenträgers angeordnet werden. Bei einer Anordnung im Frontbereich besteht zudem der Vorteil, dass der Flüssigkeitsverteiler einfach zugänglich ist. Die Vorlaufleitung und die Rücklaufleitung zum Kühlkörper auf der Steckbaugruppe können bequem mit dem Flüssigkeitsverteiler gekoppelt und an ihm befestigt werden. Auf diese Weise lassen sich auch in Schaltschränken eingebaute Baugruppenträger einfach erweitern. Der Baugruppenträger muss nicht aus dem Schaltschrank entfernt werden, um eine nachträgliche Kühleinrichtung für Steckbaugruppen zu montieren.

Bevorzugt ist der Flüssigkeitsverteiler zu diesem Zweck lösbar im Frontbereich angeordnet. Die Lösbarkeit des Verteilers erlaubt nicht nur eine einfache Montage sondern auch eine Demontage, wenn der Verteiler nicht mehr benötigt wird, oder eine Umrüstung, wenn beispielsweise ein anderer Flüssigkeitsverteiler aufgrund geänderter Anforderungen erforderlich ist.

Der erfindungsgemäße Baugruppenträger hat den Vorteil, dass der Flüssigkeitsverteiler von der Vorderseite des Baugruppenträgers frei zugänglich ist, da er sich im Frontbereich befindet. Eine Wartung und Überprüfung des Flüssigkeitsverteilers, insbesondere eine Sichtprüfung, ist besonders einfach auch während des Betriebs der Baugruppen vorzunehmen.

Bevorzugt weist der erfindungsgemäße Baugruppenträger in seinem Frontbereich eine Aufnahme vor, mittels der der Flüssigkeitsverteiler gehalten wird. Diese Aufnahme kann beispielsweise in Form eines Kragens ausgebildet sein, in den der Flüssigkeitsverteiler eingepresst, eingeklipst oder angeklammert wird. Die Aufnahme kann auch aus einer oder mehrerer Bohrungen bestehen, so dass der Flüssigkeitsverteiler im Frontbereich des Baugruppenträgers angeschraubt werden kann.

Besonders bevorzugt ist eine Aufnahme zum Halten des Flüssigkeitsverteilers an der Frontabdeckplatte des Baugruppenträgers vorgesehen. Damit sitzt der Flüssigkeitsverteiler im Frontbereich oberhalb bzw. unterhalb der Steckbaugruppen. Das Einstecken und Herausziehen von Steckbaugruppen aus dem Baugruppenträger wird nicht durch den Flüssigkeitsverteiler behindert. Diese Anordnung hat darüber hinaus den Vorteil, dass die Vorlauf- und Rücklaufleitung zu dem Kühlkörper, der auf der Steckbaugruppe angeordnet ist, relativ kurz sein können, da der Flüssigkeitsverteiler in unmittelbarer Nähe zu den Baugruppen angeordnet ist.

Alternativ kann der Flüssigkeitsverteiler auch an den Randbereichen des Baugruppenträgers, also seitlich des Einschubbereichs der Steckbaugruppen, angeordnet sein. Es kann auch eine Blindplatte vorgesehen werden, die neben bzw. zwischen zwei Steckbaugruppen im Frontbereich des Baugruppenträgers und mit den Frontplatten der Steckbaugruppen bündig angeordnet sind. Allerdings ist diese Ausführungsform nur dann sinnvoll, wenn der Baugruppenträger nicht komplett mit Steckbaugruppen bestückt ist.

Vorteilhafterweise ist der erfindungsgemäße Baugruppenträger derart ausgebildet, dass mehrere Flüssigkeitsverteiler im Frontbereich des Baugruppenträgers angeordnet werden können. So können mehrere Flüssigkeitsverteiler an einem Baugruppenträger nachgerüstet werden. Wenn mehrere Steckbaugruppen mit einer Flüssigkeitskühlung gekühlt werden sollen, kann der Baugruppenträger auch sukzessive erweitert werden, in dem je nach Bedarf und Anzahl der zu kühlenden Steckbaugruppen mehrere bzw. weitere Flüssigkeitsverteiler montiert werden. Die einzelnen Flüssigkeitsverteiler sind entsprechend klein, so dass ein platzsparender Aufbau möglich ist. Die einzelnen Flüssigkeitsverteiler können miteinander gekoppelt werden, so dass strömungstechnisch ein großer Flüssigkeitsverteiler mit vielen Anschlüssen für mehrere Kühlkörper entsteht. Auch wenn weitere Steckbaugruppen mit einer Flüssigkeitskühlung nachgerüstet werden, können die bestehenden Flüssigkeitsverteiler beibehalten werden. Es werden dann zusätzliche Flüssigkeitsverteiler montiert. Dies kann auch im "Hot-Plug-Verfahren" geschehen, wenn nur die betreffenden Steckbaugruppen gegen Steckbaugruppen mit einer Flüssigkeitskühlung ausgetauscht werden, während die nicht betroffenen Steckbaugruppen weiter arbeiten.

In einer bevorzugten Ausführungsform ist der erfindungsgemäße Baugruppenträger in einem Schrank, insbesondere in einem Elektroniksc,hrank oder Schaltschrank im 19"-Format, angeordnet. Der Schaltschrank weist Winkelprofile im Frontbereich auf, so dass der Flüssigkeitsverteiler an den Winkelprofilen des Schranks befestigt ist. Dabei können die Flüssigkeitsverteiler entweder direkt an den Winkelprofilen angeordnet und montiert sein oder an einer gesonderten Frontabdeckplatte, die beispielsweise an den beiden seitlichen Winkelprofilen des Schaltschranks fixiert wird. Auf diese Weise steht für die Nachrüstung von Flüssigkeitsverteilern mehr Platz zur Verfügung, so dass auch große Flüssigkeitsverteiler mit mehreren Vorlauf- und Rücklaufleitungen zur gleichzeitigen Versorgung von mehreren Steckbaugruppen eingesetzt werden können.

Es ist ferner vorteilhaft eine kombinierte Luft-Flüssigkeits-Kühlung vorzusehen. Neben der (standardmäßigen) Einrichtung zur Luftkühlung ist zusätzlich eine Kühleinrichtung zur Flüssigkeitskühlung vorgesehen. Auf diese Weise wird eine Kühlung von "Hot-Spots", also besonders heißer Zonen, ermöglicht. Die Steckbaugruppen können also entsprechend den einzelnen Anforderungen der Kühlung separat bzw. gezielt gekühlt werden. Bei einer Erweiterung eines luftgekühlten Baugruppenträgers durch Flüssigkeitskühlung wird auch die flüssigkeitsgekühlte Steckbaugruppe nach wie vor durch die Luftkühlung gekühlt, so dass der Wirkungsgrad der Kühlung erhöht wird.

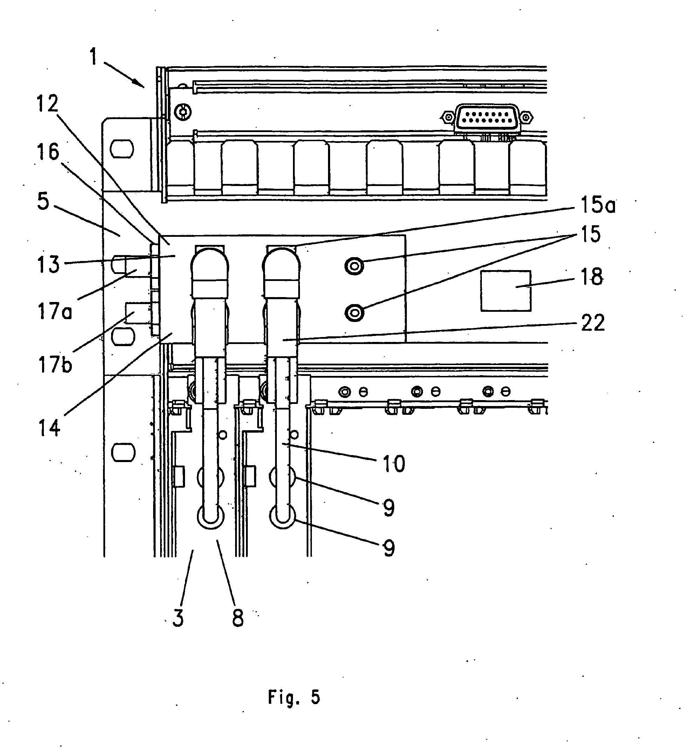

Weitere Einzelheiten, Merkmale und Vorteile der Erfindung ergeben sich aus der nachfolgenden Beschreibung bevorzugter Ausführungsbeispiele anhand der beigefügten Zeichnungen. Es zeigen:

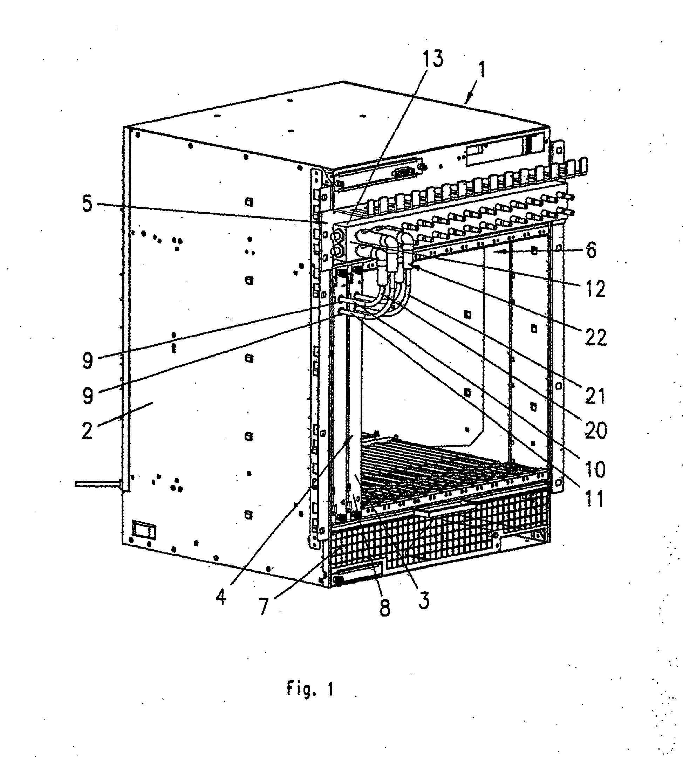

- Figur 1: einen Baugruppenträger mit einem Gehäuse und zwei eingeschobenen Steckbaugruppen;
- Figur: 2 einen Baugruppenträger mit einem Flüssigkeitsverteiler, zum Anschluss von sechs flüssigkeitsgekühlten Steckbaugruppen;
- Figur: 3 einen Baugruppenträger mit einem Flüssigkeitsverteiler, der vollständig mit flüssigkeitsgekühlten Steckbaugruppen bestückt ist;
- Figur: 4 eine Steckbaugruppe mit zwei Kühlkörpern;
- Figur: 5 einen Detailausschnitt des oberen Eckbereichs des Baugruppenträgers aus Figur 1; und
- Figur: 6eine Seitenansicht des oberen Eckbereichs aus Figur 5.

Die Figuren 1, 2 und 3 zeigen je einen Baugruppenträger 1 mit einem Gehäuse 2 in den Steckbaugruppen 3 eingeschoben sind. Im Frontbereich 4 des Baugruppenträgers 1 ist oberhalb eines Einschubbereichs 6 zum Einstecken und Herausziehen der Steckbaugruppen 3 eine Frontabdeckplatte 5 vorgesehen. Unterhalb des Einschlussbereichs 6 ist eine Lufteinlassplatte 7 angeordnet, die gitterförmig ausgebildet ist, so dass mehrere kleine Lufteintrittsöffnungen zur Luftkühlung des Baugruppenträgers 1 vorhanden sind.

In Figur 1 weisen die beiden Steckbaugruppen 3 an ihren Frontplatten 8 jeweils zwei Durchführungen 9 auf. Durch die Durchführungen 9 werden Vorlaufleitungen 10 und Rücklaufleitungen 11 einer Kühleinrichtung zur Flüssigkeitskühlung geführt.

Die oberhalb des Einschubbereichs 6 für die Steckbaugruppen 3 angeordnete Frontabdeckplatte 5 weist einen Flüssigkeitsverteiler 12 auf, der Bestandteil der Kühleinrichtung ist. Der Flüssigkeitsverteiler 12 ist auf der Frontabdeckplatte 5 des Baugruppenträgers 1 fixiert. Die Frontabdeckplatte 5 ist jedoch lösbar mit dem Gehäuse 2 des Baugruppenträgers 1 verbunden, so dass die Frontabdeckplatte 5 mitsamt dem Flüssigkeitsverteiler 12 auswechselbar ist. Die Befestigung des Flüssigkeitsverteilers 12 auf einer separaten Frontabdeckplatte 5, die lösbar an dem Baugruppenträger 1 befestigt ist, ist besonders bevorzugt, da durch einfaches Auswechseln der Frontabdeckplatte 5 die Flüssigkeitskühlung für einen Baugruppenträger 1 nachgerüstet werden kann.

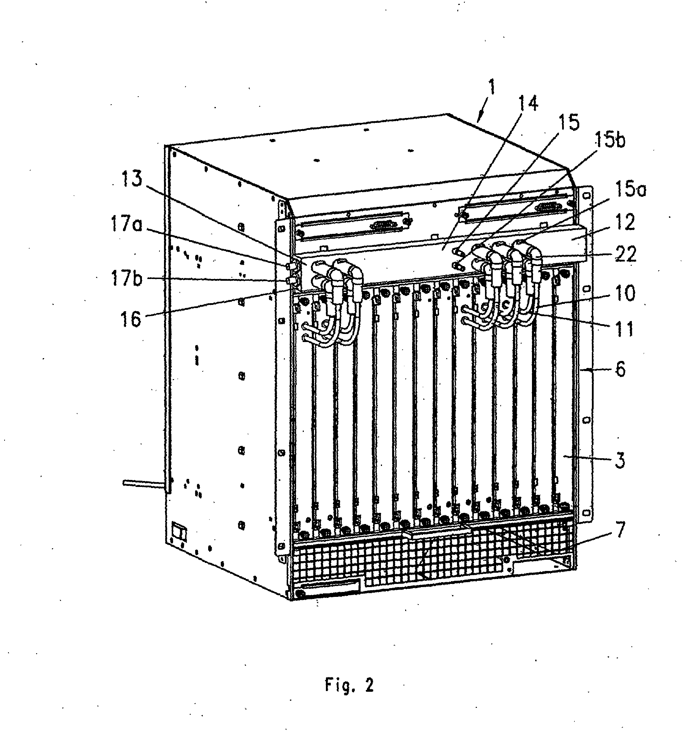

Figur 2 zeigt ebenfalls einen erfindungsgemäßen Baugruppenträger 1, dessen Einschubbereich 6 vollständig mit Steckbaugruppen 3 gefüllt ist. Fünf der Steckbaugruppen 3 sind mit einer Flüssigkeitskühlung versehen.

Der oberhalb des Einschubbereichs 6 angeordnete Flüssigkeitsverteiler 12 hat bevorzugt ein Verteilergehäuse 13 mit einer Deckseite 14, die parallel zur Frontabdeckplatte 5 ausgerichtet ist. An der Deckseite 14 sind wenigstens zwei Leitungsanschlüsse 15 zum Ankuppeln einer Kupplung 22 vorgesehen.

Der Flüssigkeitsverteiler 12 weist mehrere Leitungsanschlüsse 15 auf, die in zwei übereinander liegenden Reihen angeordnet sind. Leitungsanschlüsse 15a der oberen Reihe sind zum Anschluss der Vorlaufleitungen 10 vorgesehen; die unteren Leitungsanschlüsse 15b sind zum Anschluss der Rücklaufleitung 11 vorgesehen. Jeweils zwei Leitungsanschlüsse 15 dienen also zum Anschluss der Kühleinrichtung einer Steckbaugruppe 3.

An einer Seitenwand 16 des Verteilergehäuses 13 des Flüssigkeitsverteilers 12 sind je ein Hauptvorlauf 17a und ein Hauptrücklauf 17b angeordnet, die mit einem nicht dargestellten Wärmetauscher verbunden werden. In der Regel ist der Wärmetauscher im gleichen Schaltschrank wie der Baugruppenträger angeordnet.

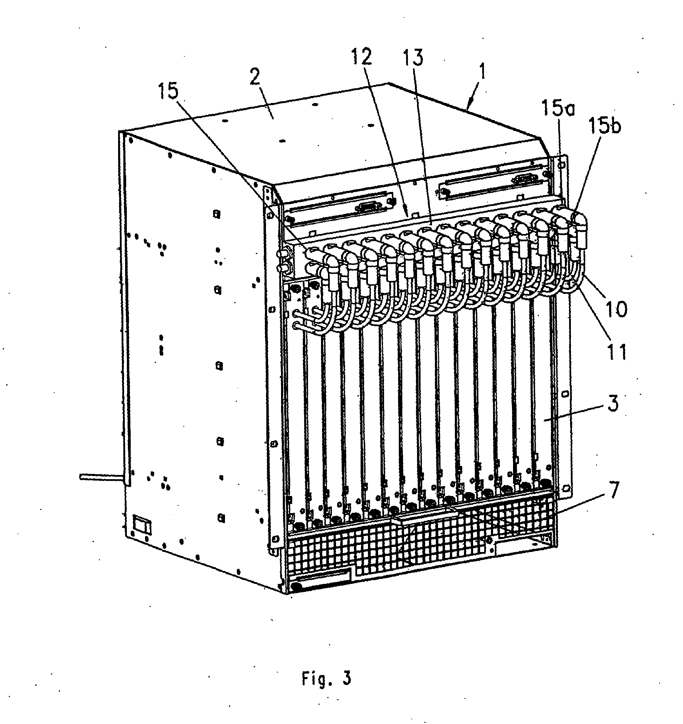

Figur 3 zeigt einen Baugruppenträger 1 mit einem Flüssigkeitsverteiler, der sich über die gesamte Breite des Baugruppenträgers 1 erstreckt und Anschlussmöglichkeiten für jede einschiebbare Steckbaugruppe 3 vorsieht. Beispielsweise umfasst ein solcher Flüssigkeitsverteiler 12 beim Einsatz in 19"-Baugruppenträgern Anschlussmöglichkeiten für insgesamt 14 Steckbaugruppen 3.

Die in den Figuren 2 und 3 explizit gezeigten Baugruppenträger 1 weisen jeweils einen Flüssigkeitsverteiler 12 auf, der sich über die gesamte Breite des Baugruppenträgers 1 erstreckt. In einer anderen Ausgestaltung des Flüssigkeitsverteilers 12 weist dieser nur Anschlüsse für wenige Steckbaugruppen 3, insbesondere für drei Steckbaugruppen 3 auf. Der Flüssigkeitsverteiler 12 erstreckt sich dann lediglich über die Breite von drei Baugruppen. Er ist als kleiner Block ausgeführt. Ein derartiger Flüssigkeitsverteiler 12 ist in Figur 5 dargestellt, die die obere linke Ecke eines Baugruppenträgers 1 zeigt. Der Flüssigkeitsverteiler 12 weist Leitungsanschlüsse 15 für insgesamt drei Baugruppen auf. Neben dem Flüssigkeitsverteiler 12 ist in der Frontabdeckplatte 5 eine Aufnahme 18 vorgesehen, an der ein weiterer Flüssigkeitsverteiler 12 befestigt werden kann, wenn später weitere Steckbaugruppen 3 mit einer Flüssigkeitskühlung versehen werden sollen. In die hier quadratisch ausgeführte Aufnahme 18 wird ein korrespondierender Clips eines Flüssigkeitsverteilers 12 eingeklipst. Auf diese Weise ist der Flüssigkeitsverteiler 12 einfach zu montieren.

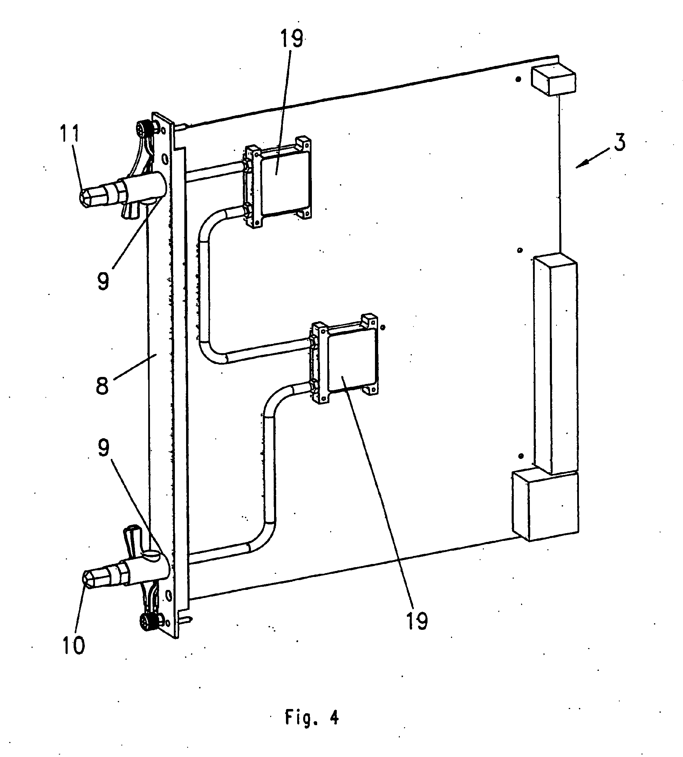

Figur 4 zeigt im Detail eine Steckbaugruppe 3 mit Kühlkörpern 19 und zwei Durchführungen 9 an ihrer Frontplatte 8 zum Durchführen der Vorlaufleitung 10 und der Rücklaufleitung 11. Diese Steckbaugruppe 3 ist ebenfalls zur Aufnahme in einen Baugruppenträger 1 geeignet.

Wie den Figuren 1, 5 und 6 zu entnehmen ist, ist am freien Ende der Vorlaufleitung 10 und der Rücklaufleitung 11 je ein flexibler Leitungsabschnitt 20 bzw. 21 vorgesehen, an denen je eine Kupplung 22 angeordnet ist. Bevorzugt sind die Kupplungen 22 bogenartig oder abgewinkelt ausgeführt. Der Winkel liegt dabei vorteilhafterweise zwischen 60 und 125°. Besonders bevorzugt ist ein Winkel von 90°, wie ihn die in den Figuren dargestellten Kupplungen 22 aufweisen. Derartige Kupplungen 22 eignen sich besonders gut zum Anschluss an einen Flüssigkeitsverteiler 12, dessen Leitungsanschlüsse 15 an der Deckseite 14 angeordnet sind. Ein Abknicken und eine sich daraus ergebende Beschädigung der Leitungsabschnitte 20, 21 wird zuverlässig ausgeschlossen.

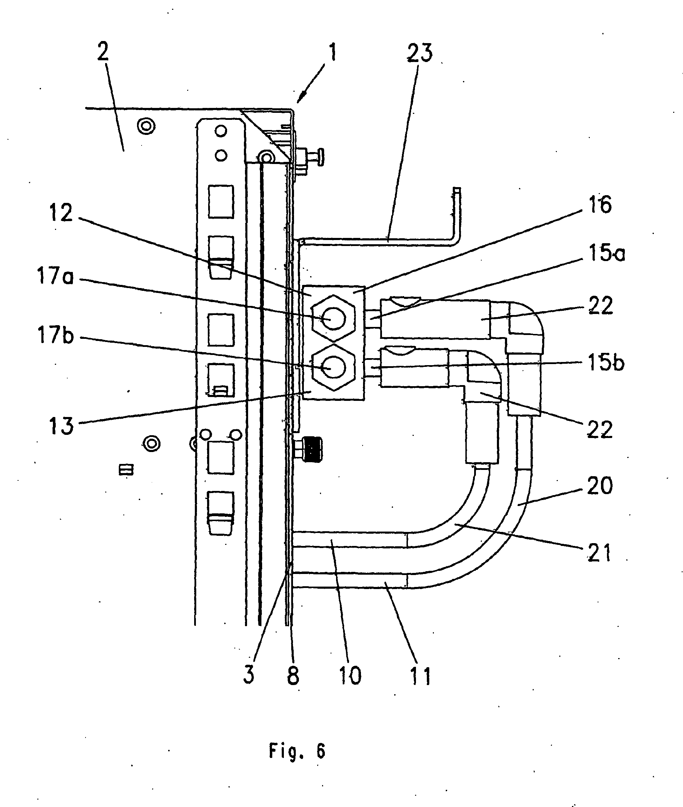

Insbesondere der Figur 6 ist zu entnehmen, dass der Flüssigkeitsverteiler 12 nur wenig über den Frontbereich 4 des Baugruppenträgers 1 herausragt, so dass der Baugruppenträger 1 mit an der Kühleinrichtung angeschlossenen Kupplungen 22 nur wenige Zentimeter tiefer ist als ein luftgekühlter Baugruppenträger. Die Kupplungen 22 erstrecken sich dabei nur wenig über ein oberhalb des Flüssigkeitsverteilers 12 angeordnetes Kabelauffangblech 23, das bei derartigen Baugruppenträgern 1 vorgesehen sein kann.

Die Baugruppenträger 1 nach den Figuren 1, 2 und 3 haben also ein kombiniertes Luft-Flüssigkeits-Kühlsystem, da die in dem Baugruppenträger 1 angeordneten Steckbaugruppen 3 zum einen über Luftkühlung und zum anderen über eine Flüssigkeitskühlung gekühlt werden können. Die Kühlluft der Luftkühlung strömt durch die Lufteinlassplatte 7 in den Baugruppenträger 1 hinein. Zusätzlich ist die Möglichkeit gegeben, durch Aufrüstung oder Nachrüstung des Baugruppenträgers 1 mit Flüssigkeitsverteilern 12 einzelne oder alle Steckbaugruppen 3 mit einer Flüssigkeitskühlung auszurüsten, um einzelne Steckbaugruppen 3 zusätzlich zu kühlen.

## Patentansprüche

1. Baugruppenträger zum Einstecken und Herausziehen von elektronischen Steckbaugruppen (3) mit einem Gehäuse (2), das eine Frontabdeckplatte (5) hat und mit einer Kühleinrichtung für Steckbaugruppen (3), umfassend einen Kühlkörper (19), der auf der Steckbaugruppe (3) angeordnet ist, und einen Flüssigkeitsverteiler (12), der über eine Vorlaufleitung (10) und eine Rücklaufleitung (11) mit dem Kühlkörper (19) in Strömungsverbindung steht, wobei der Flüssigkeitsverteiler (12) außen im Frontbereich (4) des Baugruppenträgers (3) angeordnet ist.

2. Baugruppenträger nach Anspruch 1, **dadurch gekennzeichnet, dass** im Frontbereich (4) eine Aufnahme (18) zum Halten des Flüssigkeitsverteilers (12) vorgesehen ist.

3. Baugruppenträger nach Anspruch 2, **dadurch gekennzeichnet, dass** die Aufnahme (18) an der Frontabdeckplatte (5) des Baugruppenträgers (1) vorgesehen ist.

4. Baugruppenträger nach Anspruch 1 oder 2, **dadurch gekennzeichnet, dass** der Flüssigkeitsverteiler (12) auf einer separaten Platte, vorzugsweise einer Frontabdeckplatte (5) fixiert ist, die lösbar an dem Baugruppenträger (1) befestigt ist.

5. Baugruppenträger nach einem der vorhergehenden Ansprüche, **dadurch gekennzeichnet, dass** die Steckbaugruppe (3) eine Frontplatte (8) mit wenigstens zwei Durchführungen (9) für die Rücklaufleitung (11) und die Vorlaufleitung (10) aufweist.

6. Baugruppenträger nach einem der vorhergehenden Ansprüche, **dadurch gekennzeichnet, dass** am freien Ende der Rücklaufleitung (11) und/oder der Vorlaufleitung (10) eine Kupplung (22) zum Anschluss an den Flüssigkeitsverteiler (12) vorgesehen ist.

7. Baugruppenträger nach Anspruch 6, **dadurch gekennzeichnet, dass** die Kupplung (22) bogenartig oder abgewinkelt ist, bevorzugt einen Winkel zwischen 60° und 125°, besonders bevorzugt einen Winkel von 90° aufweist.

8. Baugruppenträger nach Anspruch 6 oder 7, **dadurch gekennzeichnet, dass** der Flüssigkeitsverteiler (12) ein Verteilergehäuse (13) mit einer Deckseite (14) hat, an der wenigstens zwei Leitungsanschlüsse (15) zum Ankuppeln der Kupplung (22) vorgesehen sind.

9. Baugruppenträger nach einem der vorhergehenden Ansprüche, **dadurch gekennzeichnet, dass** mehrere Flüssigkeitsverteiler (12) im Frontbereich (4) des Baugruppenträgers (1) nachrüstbar sind.

10. Baugruppenträger nach einem der vorhergehenden Ansprüche, **dadurch** gekenntzeichnet, dass der Baugruppenträger (1) in einem Schrank angeordnet ist, der Winkelprofile im Frontbereich aufweist, und der Flüssigkeitsverteiler (12) an den Winkelprofilen des Schranks befestigt ist.

11. Baugruppenträger nach einem der vorhergehenden Ansprüche, **dadurch gekennzeichnet, dass** neben der Kühleinrichtung zur flüssigkeitskühlung eine Einrichtung zur Luftkühlung vorgesehen ist, so dass eine kombinierte Luft-Flüssigkeits-Kühlung erfolgt.

## Claims

1. Assembly support for plugging and unplugging electronic plug-in assemblies (3) with a housing (2) which has a front cover plate (5) and a cooling device for plug-in assemblies (3), comprising a cooling element (19) disposed on the plug-in assembly (3) and a liquid distributor (12) which is in communication for flow purposes with the cooling element (19) via a feed line (10) and a return line (11), the liquid distributor (12) being disposed on the outside in the front region (4) of the assembly support (3).

2. Assembly support as claimed in Claim 1, **characterised in that** a receptacle (18) is provided to hold the liquid distributor (12) is provided in the front region (4).

3. Assembly support as claimed in Claim 2, **characterised in that** the receptacle (18) is provided on the front cover plate (5) of the assembly support (1).

4. Assembly support as claimed in Claim 1 or Claim 2, **characterised in that** the liquid distributor (12) is fixed on a separate plate, preferably a front cover plate (5) which is releasably fixed on the assembly support (1).

5. Assembly support as claimed in any one of the preceding claims, **characterised in that** the plug-in assembly (3) has a front plate (8) with at least two feedthroughs (9) for the return line (11) and the feed line (10).

6. Assembly support as claimed in any one of the preceding claims, **characterised in that** a coupling (22) for connection to the liquid distributor (12) is provided on the free end of the return line (11) and/or the feed line (10).

7. Assembly support as claimed in Claim 6, **characterised in that** the coupling (22) is arcuate or angled, and preferably forms an angle between 60° and 125°, particularly preferably an angle of 90°.

8. Assembly support as claimed in Claim 6 or Claim 7, **characterised in that** the liquid distributor (12) has a distributor housing (13) with a cover face (14) on which at least two line connections (15) are provided for connection of the coupling (22).

9. Assembly support as claimed in any one of the preceding claims, **characterised in that** a plurality of liquid distributors (12) can be retrofitted in the front region (4) of the assembly support (1).

10. Assembly support as claimed in any one of the preceding claims, **characterised in that** the assembly support (1) is disposed in a cabinet which has angular profiles in the front region, and the liquid distributor (12) is fixed on the angular profiles of the cabinet.

11. Assembly support as claimed in any one of the preceding claims, **characterised in that** in addition to the cooling device for liquid cooling a device for air cooling is provided, so that a combined air and liquid cooling takes place.

## Revendications

1. Baie pour modules électroniques pour l'enfichage et le retrait de modules électroniques enfichables (3) avec un boîtier (2), qui a une plaque de couverture frontale (5), et avec un dispositif de refroidissement pour des modules enfichables (3), comprenant un corps de refroidissement (19), qui est disposé sur le module enfichable (3), et un distributeur de liquide (12), qui est en liaison d'écoulement avec le corps de refroidissement (19) par l'intermédiaire d'un conduit aller (10) et d'un conduit retour (11), le distributeur de liquide (12) étant disposé extérieurement dans la zone frontale (4) de la baie pour modules électroniques (1).

2. Baie pour modules électroniques suivant la revendication 1, **caractérisée en ce qu'**un logement (18) pour le maintien du distributeur de liquide (12) est prévu dans la zone frontale (4).

3. Baie pour modules électroniques suivant la revendication 2, **caractérisée en ce que** le logement (18) est prévu sur la plaque de couverture frontale (5) de la baie pour modules électroniques (1).

4. Baie pour modules électroniques suivant l'une des revendications 1 et 2, **caractérisée en ce que** le distributeur de liquide (12) est fixé sur une plaque séparée, de préférence une plaque de couverture frontale (5), qui est fixée de façon amovible sur la baie pour modules électroniques (1).

5. Baie pour modules électroniques suivant l'une des revendications précédentes, **caractérisée en ce que** le module enfichable (3) présente une platine avant (8) avec au moins deux traversées (9) pour la conduite retour (11) et la conduite aller (10).

6. Baie pour modules électroniques suivant l'une des revendications précédentes, **caractérisée en ce qu'**un couplage (22) pour le raccordement au distributeur de liquide (12) est prévu à l'extrémité libre de la conduite retour (11) et/ou de la conduite aller (10).

7. Baie pour modules électroniques suivant la revendication 6, **caractérisée en ce que** l'accouplement (22) est en forme d'arc ou coudé, présente de préférence un angle compris entre 60° et 125°, de façon particulièrement préférentielle un angle de 90°.

8. Baie pour modules électroniques suivant l'une des revendications 6 et 7, **caractérisée en ce que** le distributeur de liquide (12) a un boîtier répartiteur (13) avec une face de couverture (14), sur laquelle sont prévus au moins deux raccords de conduite (15) pour accoupler l'accouplement (22).

9. Baie pour modules électroniques suivant l'une des revendications précédentes, **caractérisée en ce que** plusieurs distributeurs de liquide (12) sont adaptables dans la zone frontale (4) de la baie pour modules électroniques (1).

10. Baie pour modules électroniques suivant l'une des revendications précédentes, **caractérisée en ce que** la baie (1) est disposée dans une armoire, qui présente des cornières dans la zone frontale, et le distributeur de liquide (12) est fixé sur les cornières de l'armoire.

11. Baie pour modules électroniques suivant l'une des revendications précédentes, **caractérisée en ce qu'**il est prévu un dispositif de refroidissement par air, outre le dispositif de refroidissement par liquide, de sorte qu'il s'effectue un refroidissement combiné par air - liquide.
